(19) Europäisches Patentamt
European Patent Office
Office européen des brevets

(11) **EP 1 233 462 B1**

(12) **EUROPÄISCHE PATENTSCHRIFT**

(45) Veröffentlichungstag und Bekanntmachung des Hinweises auf die Patenterteilung:
**18.07.2007 Patentblatt 2007/29**

(51) Int Cl.:
*H01L 41/083* *(2006.01)*   *H01L 41/24* *(2006.01)*

(21) Anmeldenummer: **02003090.4**

(22) Anmeldetag: **13.02.2002**

(54) **Vielschichtaktor mit versetzt angeordneten Kontaktflächen gleich gepolter Innenelektroden für ihre Aussenelektrode**

Multilayer actuator with shifted contact areas of internal electrodes having the same polarization to their external electrode

Actionneur multicouche avec zones déplacées de contact des électrodes intérieures ayant la même polarisation que leur électrode extérieur

(84) Benannte Vertragsstaaten:
**AT BE CH CY DE DK ES FI FR GB GR IE IT LI LU MC NL PT SE TR**

(30) Priorität: **15.02.2001 DE 10107505**
            **19.01.2002 DE 10201943**

(43) Veröffentlichungstag der Anmeldung:
**21.08.2002 Patentblatt 2002/34**

(73) Patentinhaber: **CeramTec AG Innovative Ceramic Engineering**
**73207 Plochingen (DE)**

(72) Erfinder: **Schreiner, Hans-Jürgen, Dr.**
**91233 Neunkirchen am Sand-Rollhofen (DE)**

(74) Vertreter: **Uppena, Franz**
**c/o Chemetall GmbH**
**Patente, Marken & Lizenzen**
**Trakehner Strasse 3**
**60487 Frankfurt am Main (DE)**

(56) Entgegenhaltungen:
EP-A- 0 550 829       EP-A- 1 061 591
WO-A-00/26972       US-A- 5 168 189

- PATENT ABSTRACTS OF JAPAN Bd. 014, Nr. 175 (E-0914), 6. April 1990 (1990-04-06) & JP 02 028977 A (TOYOTA MOTOR CORP), 31. Januar 1990 (1990-01-31)
- PATENT ABSTRACTS OF JAPAN Bd. 014, Nr. 493 (E-0995), 26. Oktober 1990 (1990-10-26) & JP 02 203579 A (HITACHI METALS LTD), 13. August 1990 (1990-08-13)
- PATENT ABSTRACTS OF JAPAN Bd. 1997, Nr. 10, 31. Oktober 1997 (1997-10-31) & JP 09 148639 A (KYOCERA CORP), 6. Juni 1997 (1997-06-06)
- PATENT ABSTRACTS OF JAPAN Bd. 1996, Nr. 10, 31. Oktober 1996 (1996-10-31) & JP 08 167746 A (KYOCERA CORP), 25. Juni 1996 (1996-06-25)
- PATENT ABSTRACTS OF JAPAN Bd. 1997, Nr. 10, 31. Oktober 1997 (1997-10-31) & JP 09 148640 A (TOKIN CORP), 6. Juni 1997 (1997-06-06)

**Beschreibung**

Die Erfindung betrifft einen piezokeramischen Vielschichtaktor entsprechend dem Oberbegriff des ersten Anspruchs sowie ein Verfahren zu seiner Herstellung.

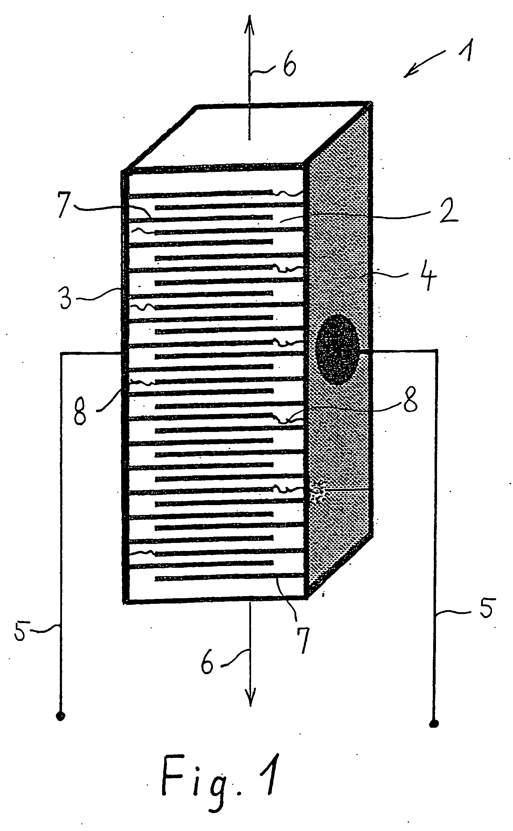

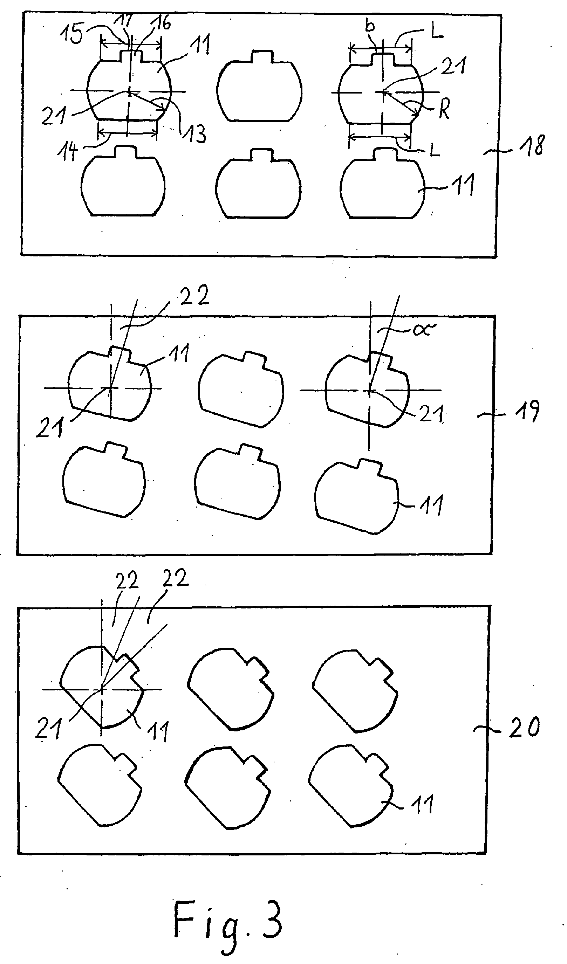

In Figur 1 ist ein piezokeramischer Vie!schichtaktor 1 nach dem Stand der Technik schematisch dargestellt. Diese Aktoren weisen eine Interdigitalstruktur auf. Sie werden als Monolithen hergestellt, das heißt, sie bestehen aus gestapelten dünnen Schichten 2 piezoelektrisch aktiven Materials, beispielsweise Blei-Zirkonat-Titanat (PZT), mit dazwischen angeordneten leitfähigen Innenelektroden 7, die alternierend an die Aktoroberfläche geführt werden. Das aktive Material wird als sogenannte Grün-Folie vor dem Sintern durch ein Siebdruckverfahren mit Innenelektroden 7 versehen, zu einem Stapel verpresst, pyrolysiert und dann gesintert, wodurch ein monolithischer Vielschichtaktor 1 entsteht.

Außenelektroden 3, 4 verbinden die Innenelektroden 7. Dadurch werden die Innenelektroden 7 jeweils auf einer Seite des Aktors 1 elektrisch parallel geschaltet und so zu einer Gruppe zusammengefasst. Die Außenelektroden 3, 4 sind die Anschlusspole des Aktors. Wird über die Anschlüsse 5 eine elektrische Spannung an die Anschlusspole gelegt, so wird diese auf alle Innenelektroden 7 parallel übertragen und verursacht ein elektrisches Feld in allen Schichten des aktiven Materials, das sich dadurch mechanisch verformt. Die Summe aller dieser mechanischen Verformungen steht an den Endflächen des Aktors als nutzbare Dehnung 6 und/oder Kraft zur Verfügung, beispielsweise zur Steuerung eines Einspritzventils bei Verbrennungsmotoren.

Bei Aktoren nach dem Stand der Technik ist es bekannt, dass in dem inaktiven Bereich, der zur Kontaktierung benötigt wird, Dehnungsinhomogenitäten auftreten. Diese verursachen in dem piezoelektrisch inaktiven Elektrodenbereich Risse, die in regelmäßigen Abständen auftreten können. Dieser Zustand ist in Figur 1 dargestellt.

Durch die Dehnungsinhomogenitäten summieren sich die Spannungen in den passiv gedehnten Bereichen bis zu einer Höhe, bei der sie sich durch Rissbildung entlasten. Die Risse 8 haben in der Regel Abstände von mehr als einem Millimeter bei Dehnungen von etwa 1 bis 2 $\mu$m/mm. Diese Risse 8 enden im sogenannten aktiven Bereich des Aktors, der die Dehnung erzeugt, weil hier nur Druckspannungen auftreten.

Die Risse können für einige Anwendungen toleriert werden. Es ergeben sich jedoch grundsätzliche Probleme. Wenn der Aktor nicht vollständig gekapselt ist, treten an den durch die Risse freigelegten Elektrodenenden elektrische Felder auf, die zur Anlagerung von Wasser oder polaren Molekülen führen können. Diese verursachen Leckströme oder führen zu einer verstärkten Degradation des Aktorverhaltens. Es ist außerdem nicht vollständig auszuschließen, dass die Aktoren, durch die Risse vorgeschädigt, aufgrund von Ausbrüchen während des Betriebs versagen. Weiterhin werden die Außenelektroden im Bereich der Risse besonders beansprucht und reißen oder lösen sich ab. Ein Versagen der Außenelektrode führt zu einem totalen Versagen eines Aktors.

Ein gattungsgemäßer Aktor mit gegeneinander versetzt angeordneten inaktiven Bereichen ist zum Beispiel in EP 1 061 591 A1 offenbart. Ein entsprechendes Herstellungsverfahren ist aus EP 0 550 829 A1 zu entnehmen.

Aufgabe der Erfindung ist es, die Ursachen für das Auftreten von rissbildenden Spannungen weitestgehend zu beseitigen.

Die Lösung der Aufgabe erfolgt vorrichtungsgemäß mit Hilfe der kennzeichnenden Merkmaie des ersten, verfahrensgemäß mit Hilfe des siebzehnten Anspruchs. Vorteilhafte Ausgestaltungen der Erfindung werden in den abhängigen Ansprüchen beansprucht.

Ein erfindungsgemäßer Vielschichtaktor unterscheidet sich von Aktoren nach dem Stand der Technik dadurch, dass die mit ihrer Aussenelektrode zu kontaktierenden Flächen gleich gepolter Innenelektroden nicht in gerader Richtung übereinander liegen, sondern um einem gemäß dem kennzeichnenden Teil des Anspruchs 1 um einen winkel $\alpha$ versetzt sind. Die Innenelektroden des erfindungsgemäßen Vielschichtaktors weisen einen von ihrer Grundfläche abgegrenzten, zungenförmigen, nach außen weisenden

Kontaktbereich auf. Die Stirnseiten dieser Kontaktbereiche sind die Kontaktflächen. Nur diese Kontaktflächen reichen an die Oberfläche des Aktors und werden an die jeweiligen Aussenelektrode zur Verbindung der gleich gepolten Innenelektroden angeschlossen. Durch die beschriebene Formgebung der Innenelektroden entsteht im zungenförmigen Kontaktbereich ein inaktiver Bereich mit einer vorgebbaren Breite. Die Kontaktflächen und damit die ihnen zugeordneten inaktiven Bereiche einer oder einer vorgegebenen Anzahl in gleicher Richtung übereinander angeordneter, gleich gepolter Innenelektroden sind gegenüber den Kontaktflächen und damit den diesen zugeordneten inaktiven Bereichen der vorhergehenden Innenelektrode oder einer vorgegebenen Anzahl gleich ausgerichteter vorhergehender Innenelektroden gleicher Polung um einen vorgegebenen Winkel $\alpha$ versetzt angeordnet. Hierdurch entstehen inaktive Bereiche, die passiv gedehnt werden.

Die zu kontaktierenden Flächen der Innenelektroden gleicher Polung und die inaktiven Bereiche werden also entsprechend der Erfindung in regelmäßigen Abständen um einen vorgebbaren Winkel versetzt angeordnet. Der Vorteil gegenüber dem Stand der Technik ist, dass sich die Spannungen in den inaktiven Bereichen nicht mehr zu einer solchen Höhe summieren können, dass Risse entstehen.

Nach einer vorgegebenen Höhe die sich nach der Größe der in diesem Bereich auftretenden Spannungen richtet, sollte der Versatz als ein Vielfaches des Winkels $\alpha$ so groß sein, dass sich mindestens' die Kontaktflächen der ersten und der letzten der gleich gepolten Innenelektroden in diesem Bereich nicht mehr überlappen. Dadurch wird die kritische Distanz überwunden, in der sich Risse bilden. Ein solcher Versatz einer vorgegebenen Höhe kann in einem Vielschichtaktor, je nach dessen Größe, mehrfach hintereinander vorgesehen werden und kann bereits etwa alle 0,5 mm abgeschlossen sein, sollte aber, in Abhängigkeit von der Aktorgröße, spätesten nach etwa 3 mm abgeschlossen sein, damit die Wirkung des Spannungsabbaus eintreten kann. Ein vorteilhafter Bereich liegt etwa zwischen 1 mm und 1,5 mm.

Die Dicke einer Lage, das ist die Dicke der piezokeramischen Schicht und die Dicke der Innenelektrode, beträgt in der Regel 100 $\mu$m, das sind 0,1 mm. Der Versatz, bei dem sich die Kontaktflächen oder die inaktiven Bereiche nicht mehr überdecken, kann bereits nach etwa fünf Lagen auftreten, sollte nach etwa 30 Lagen abgeschlossen sein. Der als vorteilhaft anzusehende Bereich liegt etwa zwischen 10 und 15 Lagen. Der Versatz zur Beseitigung der Überdeckung der Kontaktflächen und der inaktiven Bereiche kann so erfolgen, dass jede Schicht gegenüber der nachfolgenden Schicht mit gleich gepolter Innenelektrode um einen vorgegebenen Winkel versetzt angeordnet wird. Es können aber auch zwei oder mehr Schichten mit gleich gepolten Innenelektroden zunächst in gleicher Anordnung übereinanderliegen, bevor ein Versatz um einen vorgegebenen Winkel erfolgt.

Möglich ist auch, den Versatz nach Abschluss eines Bereichs oder mehrerer Bereiche nicht nur in einer Richtung weiterzuführen, sondern in die entgegengesetzte Richtung wieder zurück, so dass ein wellenförmiger Verlauf der Versatze erfolgt. Die Aufbringung der Aussenelektrode gestaltet sich dadurch allerdings schwieriger

Die Aktoren können einen kreisförmige Querschnitt aufweisen. Die Querschnittsfläche kann aber auch ein Quadrat, ein Rechteck oder ein Vieleck sein. Bei Verbindung der Kontaktflächen gleich gepolter Innenelektroden bei einem Aktor mit kreisförmigem Querschnitt und stetig verlaufendem Versatz hat die Aussenelektrode einen schraubenlinienförmigen Verlauf. Bei den übrigen Gestaltungsbeispielen kann eine Aussenelektrode über eine oder, insbesondere bei einem vieleckigen Querschnitt, über mehrere Seitenflächen verlaufen.

Zur Befestigung können die Vielschichtaktoren eine in ihrer Längsachse verlaufende durchgehende Bohrung aufweisen, wobei es vorteilhaft ist, sie noch vor dem Sintern in den weichen Grünkörper einzubringen.

Zur Herabsetzung der Spannung in den inaktiven Kopf- und Fußbereichen der Aktoren kann durch kontinuierliches Absenken der Betriebsfeldstärke der Übergang vom aktiven zum inaktiven Bereich gleichförmiger gestaltet werden. Das Absenken der Betriebsfeldstärke wird dadurch erreicht, dass im Kopf- und Fußbereich der Abstand der Innenelektroden von Elektrode zu Elektrode zum jeweiligen Ende des Aktors hin vergrößert wird.

Anhand eines Ausführungsbeispiels wird die Erfindung näher erläutert. Das Ausführungsbeispiel zeigt den Aufbau eines Vielschichtaktors 10 mit kreisförmigem Querschnitt und kontinuierlichem Versatz. Es zeigen:

Figur 2     die Aufsicht auf eine erfindungsgemäß gestaltete Innenelektrode,

Figur 3     Grünfolien aus piezokeramischem Werkstoff für aufeinanderfolgende Lagen des Vielschichtaktors mit mehreren Innenelektroden,

Figur 4     die Aufsicht auf die Anordnung unterschiedlich gepolter Innenelektroden und

Figur 5     die Seitenansicht des Aktors.

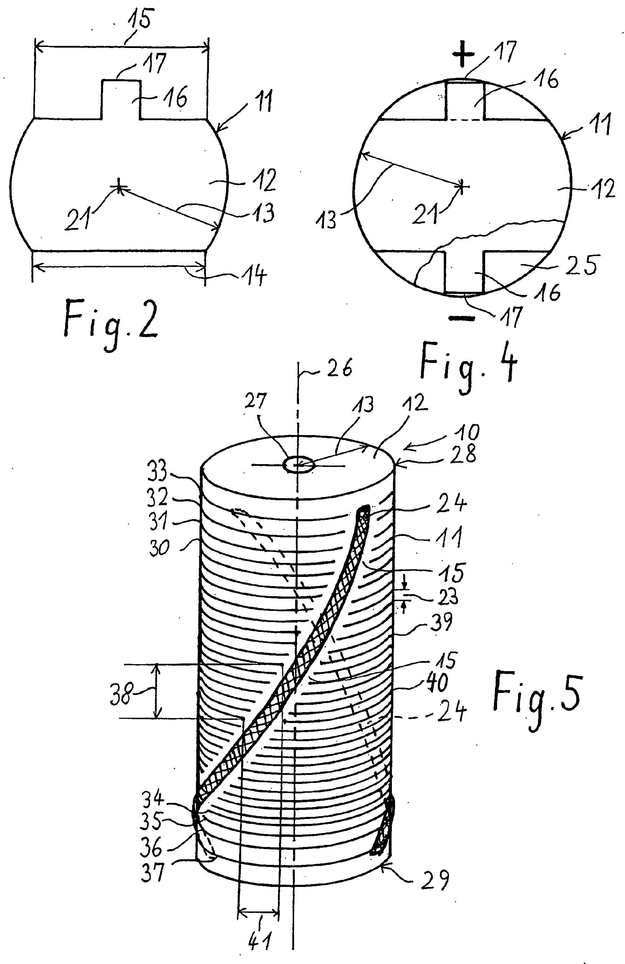

In Figur 2 ist die erfindungsgemäße Gestaltung einer Innenelektrode 11 dargestellt. Von der kreisförmigen Querschnittsfläche 12 mit dem Radius (R) 13 ist auf einer Seite ein Kreisabschnitt mit einer Sekante 14 der Länge L abgeschnitten. Auf der gegenüberliegenden Seite ist von dem gleich großen Kreisabschnitt mit der gleich langen Sekante 15 ein von der verbliebenen Grundfläche 12 abgegrenzter zungenförmiger, nach außen weisender Kontaktbereich 16 verblieben. Da die Innenelektrode 11 eine bestimmte Dicke aufweist, ist die Sekante des Kontaktbereichs 16 mit der Breite b die Kante der Kontaktfläche 17 zum Anschluss an die Aussenelektrode.

Figur 3 zeigt drei Grünfolien 18, 19, 20. Auf diesen sind jeweils sechs Innenelektroden 11 der erfindungsgemäßen Gestaltung aufgetragen, wobei dieses Auftragen üblicherweise im Siebdruck erfolgt. Die Belegung einer Grünfolie mit mehreren Innenelektroden ermöglicht die rationelle Herstellung mehrerer Vielschichtaktoren gleichzeitig. Die Folien werden in der erforderlichen Anzahl so übereinandergestapelt, dass die Innenelektroden übereinanderliegen, und dann, wegen der leichten Trennbarkeit möglichst noch im Grünzustand, um die Innenelektroden herum voneinander getrennt. Anschließend kann, ebenfalls noch im Grünzustand, die Fertigbearbeitung der Vielschichtaktoren bis auf den vorgegebenen Gründurchmesser des Vielschichtaktors erfolgen.

Die Anordnung der Innenelektroden 11 auf der jeweiligen Grünfolie 18, 19 oder 20 ist jeweils in derselben Ausrichtung. Es sind beispielsweise die erste, dritte und fünfte Folie. In der jeweils nachfolgenden Folie erfolgt erfindungsgemäß ein Versatz in der Ausrichtung der Innenelektroden, das heißt eine Drehung um ihren Mittelpunkt 21 um einen vorgegebenen Winkel 22 der Größe $\alpha$. Die drei Grünfolien 18, 19 und 20 zeigen also Innenelektroden der gleichen Polung.

Die Innenelektroden der gegensätzlichen Polung können in derselben Weise hergestellt werden. Dabei ist aber deren Ausrichtung gegenüber der Ausrichtung der ihnen zugeordneten Innenelektrode gegensätzlicher Polung, also auf der zweiten, vierten und sechsten Folie, jeweils um 180 Grad gedreht. Die Elektrodenlagen mit verschiedener Polarität wechseln sich alternierend ab. Eine Anordnung von gegensätzlich gepolten Innenelektroden aufeinanderfolgender Folien zeigt die Aufsicht auf einen Schnitt durch den Vielschichtaktor 10 in Figur 4. Die Kontaktfläche 17 des Pluspols liegt der Kontaktfläche 17 des Minuspols um 180 Grad gedreht gegenüber, durch die Keramikfolie 25 voneinander getrennt.

Wie bereits oben dargelegt, sollen sich nach einer vorgegebenen Höhe h (38 in Fig. 5) mindestens die Kontaktflächen 17 (b) nicht mehr überlappen, damit eine Rissbildung in den inaktiven Bereichen vermieden wird. Die Wirkung wird optimiert, wenn sich nach der kritischen Distanz h die inaktiven Bereiche der ersten und der letzten Folienlage nicht mehr überdecken. Der Winkel 22 der Größe $\alpha$, um den eine Innenelektrode gegenüber der nachfolgenden Elektrode mit der gleichen Polarität gedreht werden muss, berechnet sich bei vorgegebener Höhe h wie folgt:

$$\alpha = \left( \frac{h}{d} \cdot \arcsin\left( \frac{L}{R} \right) \right),$$

wobei d (23 in Fig. 5) die Gesamtdicke der piezokeramischen Schicht, der Grünfolie 25, und der Dicke der Elektrodenschicht 11 und R der Radius 13 des Vielschichtaktors ist.

Die Folien werden nach dem Aufeinanderstapeln laminiert, wobei ein Folienstapel, ein Block, mehrere Vielschichtaktoren umfassen kann. Im vorliegenden Ausführungsbeispiel sind es aufgrund der auf den Grünfolien aufgedruckten Innenelektroden sechs. Die Aktoren werden beispielsweise mittels einer Trennvorrichtung in sechs einzelne, rechteckige Quader zerteilt. Jeder der Quader entspricht dann einem Aktor. Die Quader werden im Grünzustand so auf den gewünschten Durchmesser abgedreht, dass neben den zu kontaktierenden Flächen inaktive Bereiche zur Isolierung an der Oberfläche entstehen. Danach werden die Aktoren gesintert, wobei durch die homogene Sinterschwindung das gewünschte Endmaß erreicht wird. Im gesinterten Zustand werden die Enden planparallel geschliffen. Von der übrigen Oberfläche müssen nur die zu kontaktierenden Bereiche, die Kontaktflächen 17 zum Anschluss der Aussenelektrode 24, durch Schleifen freigelegt werden. Die Kontaktflächen 17 werden mit einer Grundmetallisierung versehen und anschließend eine Elektrode aus einem geeigneten Werkstoff, beispielsweise eine Siebelektrode aus Invar, dem Verlauf der Anschlussflächen folgend aufgelötet. Entsprechend einem weiteren Ausführungsbeispiel kann die Elektrodenschicht auch nur aus einer leitenden Schicht ohne zusätzliche Aussenelektrode bestehen.

Nach der Trennung der einzelnen Aktoren aus dem Folienstapel kann die endgültige Formgebung auch nach dem Sintern erfolgen.

Figur 5 zeigt in schematischer, stark vergrößerter Darstellung einen erfindungsgemäßen Vielschichtaktor 10 mit kreisförmigen Querschnitt und schraubenlinienförmig verlaufenden Aussenelektroden 24. Während die Aussenelektrode auf der Frontseite fast vollständig zu sehen ist, ist der Verlauf der Aussenelektrode, die die gegensinnig gepolten Innenelektroden 11 miteinander verbindet, nicht zu sehen und deshalb gestrichelt eingezeichnet. Zentrisch zur Längsachse 26 verläuft eine Bohrung 27 zur Befestigung des Aktors. Im Kopfbereich 28 und im Fußbereich 29 wird der Übergang zum inaktiven Bereich in Bezug auf auftretende Spannungen dadurch gleichförmig gestaltet, dass durch Vergrößern der Abstände der Innenelektroden zum jeweiligen Ende hin die Betriebsfeldstärke gesenkt wird. Der Abstand zwischen den Elektroden 30, 31, 32, und 33 am Kopf 28 vergrößert sich von Elektrode zu Elektrode zum Ende des Aktors hin. Ebenso vergrößert sich im Fußbereich 29 der Abstand zwischen den Elektroden 34, 35, 36 und 37. Durch die Vergrößerung der Abstände werden die mechanischen Spannungen auf ein größeres Bauteilvolumen verteilt und überschreiten dadurch nicht mehr die für die Rissbildung kritische Größe.

Die übrigen Innenelektroden 11 haben alle den gleichen Abstand voneinander. Die durch die Aussenelektroden 24 miteinander verbundenen Kontaktflächen und damit die inaktiven Bereiche 15 sind kontinuierlich um denselben Winkel gegeneinander versetzt. Die kritische Distanz 38 (h), nach der im vorliegenden Ausführungsbeispiel der Versatz 41 so groß ist, dass keine Überlappung der inaktiven Bereiche 15 gleich gepolter Elektroden 11 mehr vorliegt, ist nach sechs Elektrodenlagen oder Schichten 23 erreicht, wie zwischen den Elektroden 39 und 40 abzählbar ist.

## Patentansprüche

1. Piezokeramischer Vielschichtaktor (10) mit alternierend an die Aktoroberfläche geführten Innenelektroden (11; 30 bis 37; 39, 40) und ihnen zugeordneten inaktiven Bereichen welche durch jeweils zwei von der Innenelektrode abgeschnittenen, gegenüberliegenden Kreisabschnitte mit gleich langen Sekanten (14,15) gebildet werden, wobei auf einer Seite ein nach außen weisender Kontaktbereich (16) verbleibt, wobei die gleich gepolten Innenelektroden mit den Kontaktflächen (17) ihrer Kontaktbereiche (16) zur Parallelschaltung an die jeweilige Aussenelektrode (24) angeschlossen sind und die Aussenelektroden (24) auf sich gegenüberliegenden Seiten des Aktors (10) angeordnet sind, wobei die Kontaktflächen (17) und damit die ihnen zugeordneten inaktiven Bereiche (15) einer oder einer vorgegebenen Anzahl in gleicher Richtung übereinander angeordneter, gleich gepolter Innenelektroden (11; 30 bis 37; 39, 40) gegenüber den Kontaktflächen (17) und damit den diesen zugeordneten inaktiven Bereichen der vorhergehenden Innenelektrode oder einer vorgegebenen Anzahl gleich ausgerichteter vorhergehender Innenelektroden gleicher Polung um einen Winkel (22) αa versetzt zueinander angeordnet sind, wobei sich der Winkel (22) α, um den eine Innenelektrode gegenüber der nachfolgenden Elektrode mit der gleichen Polarität gedreht werden muss, sich bei einer zur Vermeidung von Rissbildung vorgegebenen Höhe h der Folienlagen nach der sich zumindest die Kontaktflächen (17) nicht mehr überlappen,

wie folgt berechnet: $\alpha = \left( \dfrac{h}{d} \cdot \text{arcsin}\left( \dfrac{L}{R} \right) \right)$, wobei d (23) die Gesamtdicke der Grünfolie (25) zusammen mit der Dicke der Elektrodenschicht (11) ist, L die Länge der Sekante (14, 15) des abgeschnittenen Kreisabschnitts auf der Querschnittsfläche der Innenelektrode (11) und R der Radius (13) des Vielschichtaktors (10) ist.

2. Piezokeramischer Vielschichtaktor nach Anspruch 1, **dadurch gekennzeichnet, dass** nach einer vorgegebenen Höhe (38) und damit einer vorgegebenen Anzahl von Schichten (23), bestehend aus einer Schicht piezokeramischen Werkstoff (25) mit aufgebrachter Innenelektrode (11), der Versatz (41) als ein Vielfaches des vorgegebenen Winkels (22) so groß ist, dass sich mindestens die Kontaktflächen (17) der ersten (39) und der letzten (40) der gleich gepolten Innenelektroden (11) in diesem Bereich (38) nicht mehr überlappen.

3. Piezokeramischer Vielschichtaktor nach Anspruch 1, **dadurch gekennzeichnet, dass** nach einem Bereich einer vorgegebenen Höhe (38) und damit einer vorgegebenen Anzahl von Schichten (23), bestehend aus einer Schicht piezokeramischen Werkstoff (25) mit aufgebrachter Innenelektrode (11), der Versatz (41) als ein Vielfaches des vorgegebenen Winkels (22) so groß ist, dass sich die inaktiven Bereiche (15) der ersten (39) und der letzten (40) der gleich gepolten Innenelektroden (11) in diesem Bereich (38) nicht mehr überlappen.

4. Piezokeramischer Vielschichtaktor nach einem der Ansprüche 1 bis 3, **dadurch gekennzeichnet, dass** der Versatz (41) in einem Bereich (38) von etwa 0,5 mm bis etwa 3 mm abgeschlossen ist, entsprechend etwa 5 bis etwa 30 Lagen (23), die jeweils aus dem piezokeramischen Werkstoff (25) und der darauf aufgebrachten Innenelektrode (11) bestehen.

5. Piezokeramischer Vielschichtaktor nach Anspruch 4, **dadurch gekennzeichnet, dass** der Versatz (41) in einem Bereich (38) von etwa 1 mm bis etwa 1,5 mm abgeschlossen ist, entsprechend etwa 10 bis etwa 15 Lagen (23).

6. Piezokeramischer Vieischichtaktor nach einem der Ansprüche 1 bis 5, **dadurch gekennzeichnet, dass** ein Versatz (41) in einem Vielschichtaktor (10), je nach dessen Größe, mehrfach hintereinander vorgesehen ist.

7. Piezokeramischer Vielschichtaktor nach Anspruch 6, **dadurch gekennzeichnet, dass** der Versatz (41) jeweils nach Abschluss eines Bereichs oder mehrerer Bereiche (38) in die entgegengesetzte Richtung zurück geführt ist, so dass ein wellenförmiger Verlauf der Versatze erfolgt.

8. Piezokeramischer Vielschichtaktor nach einem der Ansprüche 1 bis 7, **dadurch gekennzeichnet, dass** der Aktor (10) einen kreisförmigen Querschnitt (12) aufweist.

9. Piezokeramischer Vielschichtaktor nach Anspruch 8, **dadurch gekennzeichnet, dass** bei Verbindung der Kontaktflächen (17) gleich gepolter Innenelektroden (11; 30 bis 37; 39, 40) bei einem stetig verlaufenden Versatz (41) der Kontaktflächen (17) die Aussenelektroden (24) einen schraubenlinienförmigen Verlauf aufweisen.

10. Piezokeramischer Vieischichtaktor nach einem der Ansprüche 1 bis 7, **dadurch gekennzeichnet, dass** seine Querschnittsfläche ein Quadrat, ein Rechteck oder ein Vieleck ist.

11. Piezokeramischer Vielschichtaktor nach Anspruch 10, **dadurch gekennzeichnet, dass** eine Aussenelektrode über eine oder, insbesondere bei einem vieleckigen Querschnitt, über mehrere Seitenflächen verläuft.

12. Piezokeramischer Vielschichtaktor nach einem der Ansprüche 1 bis 11, **dadurch gekennzeichnet, dass** er eine in seiner Längsachse (26) verlaufende durchgehende Bohrung (27) aufweist.

13. Piezokeramischer Vielschichtaktor nach einem der Ansprüche 1 bis 11, **dadurch gekennzeichnet, dass** Sacklöcher an seinen Enden vorgesehen sind.

14. Piezokeramischer Vielschichtaktor nach einem der Ansprüche 1 bis 13, **dadurch gekennzeichnet, dass** im Kopfbereich (28) und im Fußbereich (29) des Aktors (10) der Abstand der Innenelektroden (30 bis 33 beziehungsweise 34 bis 37) von Elektrode zu Elektrode zum jeweiligen Ende (28 beziehungsweise 29) des Aktors (10) hin vergrößert wird.

15. Piezokeramischer Vielschichtaktor nach einem der Ansprüche 1 bis 14, **dadurch gekennzeichnet, dass** der Aktor (10) Bestandteil zur Steuerung eines Einspritzventils ist.

**16.** Verfahren zur Herstellung eines Vielschichtaktors nach einem der Ansprüche 1 bis 15, **dadurch gekennzeichnet, dass** mehrere Innenelektroden gleicher Polung mit einer gleichen Ausrichtung ihrer Kontaktflächen für die Aussenelektrode jeweils auf eine Grünfolie aus einem piezokeramischen Werkstoff aufgebracht werden, dass zur Erreichung des Versatzes der Kontaktflächen die Innenelektroden derselben Polung auf der nachfolgenden Grünfolie mit dem jeweiligen Versatz durch einen vorgegebenen Winkel α zur Stellung der vorhergehenden Elektrode aufgebracht werden, dass die entsprechenden Innenelektroden der gegensätzlichen Polung jeweils um 180 Grad gedreht auf die Grünfolien aufgebracht werden, dass dann die Grünfolien gegensätzlicher Polung zu einem Block aufeinandergelegt werden, wobei die Kontaktflächen und damit die ihnen zugeordneten inaktiven Bereiche einer oder einer vorgegebenen Anzahl in gleicher Richtung übereinander angeordneter, gleich gepolter Innenelektroden gegenüber den Kontaktflächen und damit den diesen zugeordneten inaktiven Bereichen der vorhergehenden Innenelektrode oder einer vorgegebenen Anzahl gleich ausgerichteter vorhergehender Innenelektroden gleicher Polung um den Winkel α versetzt zueinander angeordnet werden und dass der Winkel der Größe α, um den eine Innenelektrode gegenüber der nachfolgenden Elektrode mit der gleichen Polarität gedreht werden muss, sich bei der zur Vermeidung von Rissbildung vorgegebenen Höhe h der Folienlagen wie folgt berechnet:

$$\alpha = \left( \frac{h}{d} \cdot \arcsin\left( \frac{L}{R} \right) \right),$$ wobei d die Gesamtdicke der Grünfolie zusammen mit der Dicke der Elektrodenschicht ist, L die Länge der Sekante des abgeschnittenen Krisabschnitts auf der Querschnittsfläche der Innenelektrode und R der Radius des Vielschichtaktors ist und dass anschließend die Aktoren aus diesem Block herausgearbeitet werden.

**17.** Verfahren zur Herstellung eines Vielschichtaktors nach Anspruch 16, **dadurch gekennzeichnet, dass** die Bearbeitung zur Formgebung eines Vielschichtaktors im Grünzustand vor dem Sintern durchgeführt wird.

**18.** Verfahren zur Herstellung eines Vielschichtaktors nach Anspruch 16, **dadurch gekennzeichnet, dass** die Bearbeitung zur Formgebung eines Vielschichtaktors nach dem Sintern durchgeführt wird.

**19.** Verfahren zur Herstellung eines Vielschichtaktors nach nach einem der Ansprüche 16 bis 18, **dadurch gekennzeichnet, dass** nach dem Sintern des Aktors die Sinterhaut auf seiner Oberfläche belassen wird und nur die Bereiche zur Freilegung der Elektroden angeschliffen werden, an denen die Kontaktflächen der Innenelektroden mit der Aussenelektrode verbunden werden.

**Claims**

**1.** A piezoceramic multilayer actuator (10) having internal electrodes (11; 30 to 37; 39, 40) alternately led to the actuator surface and inactive regions that are assigned to them and are formed by, in each case, two opposing circle segments that are cut off from the internal electrode with secants (14, 15) of identical length, with one contact region (16) that points outwards remaining on one side, with the identically poled internal electrodes being connected with the contact surfaces (17) of their contact regions (16), for the purposes of parallel connection, to the respective external electrode (24), and the external electrodes (24) being arranged on opposing sides of the actuator (10), with the contact surfaces (17), and thus the inactive regions (15) assigned to them, of one or a predetermined number of identically poled internal electrodes (11; 30 to 37; 39, 40) that are arranged one on top of the other in the same direction being arranged with respect to the contact surfaces (17), and thus the inactive regions assigned to them, of the preceding internal electrode or a predetermined number of identically aligned, preceding internal electrodes of identical polarity so that they are offset in relation to each other by an angle (22) α, with the angle (22) α, about which an internal electrode has to be turned in relation to the following electrode with the same polarity, given a height h of the film layers that is predetermined in order to avoid cracking and after which at least the contact surfaces (17) no longer overlap, being calculated as follows:

$$\alpha = \left( \frac{h}{d} \cdot \arcsin\left( \frac{L}{R} \right) \right),$$ where d (23) is the total thickness of the green film (25) together with the thickness of the electrode layer (11), L is the length of the secant (14, 15) of the cut-off circle segment on the cross-sectional area of the internal electrode (11), and R is the radius (13) of the multilayer actuator (10).

**2.** A piezoceramic multilayer actuator according to claim 1, **characterised in that** after a predetermined height (38) and thus a predetermined number of layers (23), consisting of a layer of piezoceramic material (25) with an internal electrode (11) applied thereto, the offset (41) as a multiple of the predetermined angle (22) is of such a size that at least the contact surfaces (17) of the first (39) and the last (40) of the identically poled internal electrodes (11) no longer overlap in this region (38).

3. A piezoceramic multilayer actuator according to claim 1, **characterised in that** after a region of a predetermined height (38) and thus a predetermined number of layers (23), consisting of a layer of piezoceramic material (25) with an internal electrode (11) applied thereto, the offset (41) as a multiple of the predetermined angle (22) is of such a size that the inactive regions (15) of the first (39) and the last (40) of the identically poled internal electrodes (11) no longer overlap in this region (38).

4. A piezoceramic multilayer actuator according to one of claims 1 to 3, **characterised in that** the offset (41) is completed in a region (38) of approximately 0.5 mm to approximately 3 mm, corresponding to approximately 5 to approximately 30 layers (23) consisting, in each case, of the piezoceramic material (25) and the internal electrode (11) applied thereto.

5. A piezoceramic multilayer actuator according to claim 4, **characterised in that** the offset (41) is completed in a region (38) of approximately 1 mm to approximately 1.5 mm, corresponding to approximately 10 to approximately 15 layers (23).

6. A piezoceramic multilayer actuator according to one of claims 1 to 5, **characterised in that** an offset (41) is provided in a multilayer actuator (10) several times in succession, depending on its size.

7. A piezoceramic multilayer actuator according to claim 6, **characterised in that** the offset (41) in each case after termination of one region or a plurality of regions (38) is taken back in the opposite direction so that a wave-shaped course of the offsets ensues.

8. A piezoceramic multilayer actuator according to one of claims 1 to 7, **characterised in that** the actuator (10) has a circular cross-section (12).

9. A piezoceramic multilayer actuator according to claim 8, **characterised in that** when connecting the contact surfaces (17) of identically poled internal electrodes (11; 30 to 37; 39, 40) with a constantly extending offset (41) of the contact surfaces (17) the external electrodes (24) have a helical course.

10. A piezoceramic multilayer actuator according to one of claims 1 to 7, **characterised in that** its cross-sectional area is a square, a rectangle or a polygon.

11. A piezoceramic multilayer actuator according to claim 10, **characterised in that** an external electrode extends over one side face or, in particular in the case of a polygonal cross section, over a plurality of side faces.

12. A piezoceramic multilayer actuator according to one of claims 1 to 11, **characterised in that** it has a through bore (27) extending along its longitudinal axis (26).

13. A piezoceramic multilayer actuator according to one of claims 1 to 11, **characterised in that** pocket holes are provided at its ends.

14. A piezoceramic multilayer actuator according to one of claims 1 to 13, **characterised in that** in the head region (28) and in the foot region (29) of the actuator (10) the spacing of the internal electrodes (30 to 33 and 34 to 37 respectively) from electrode to electrode is increased towards the respective end (28 and 29 respectively) of the actuator (10).

15. A piezoceramic multilayer actuator according to one of claims 1 to 14, **characterised in that** the actuator (10) is a component part for the control of an injection valve.

16. Method for the manufacture of a multilayer actuator according to one of claims 1 to 15, **characterised in that** a plurality of internal electrodes of identical polarity with identical alignment of their contact surfaces for the external electrode are in each case applied to a green film made from a piezoceramic material, **in that** in order to achieve the offset of the contact surfaces the internal electrodes of the same polarity are applied to the following green film with the respective offset through a predetermined angle α to the position of the preceding electrode, **in that** the corresponding internal electrodes of the opposite polarity are applied to the green films in each case turned through 180 degrees, **in that** then the green films of opposite polarity are laid one upon the other to form a block, with the contact surfaces and thus the inactive regions, assigned to them, of one or a predetermined number of identically poled internal electrodes arranged one on top of the other in the same direction being arranged with respect to the contact surfaces and thus the inactive regions, assigned to them, of the preceding internal electrode or a predetermined number of identically aligned, preceding internal electrodes of identical polarity so that they are offset in relation to each other by the angle α, and **in that** the angle of size α, about which an internal electrode has to be turned with respect to the following electrode with the same polarity, given the height h of the film layers that is predetermined in order to avoid cracking, is calculated as follows:

$$\alpha = \left( \frac{h}{d} \cdot \arcsin\left( \frac{L}{R} \right) \right),$$ where d is the total thickness of the green film together with the thickness of the electrode layer, L is the length of the secant of the cut-off circle segment on the cross-sectional area of the internal electrode, and R is the radius of the multilayer actuator, and **in that** subsequently the actuators are worked up out of this block.

17. Method for the manufacture of a multilayer actuator according to claim 16, **characterised in that** the processing for shaping a multilayer actuator in the green state is conducted prior to sintering.

18. Method for the manufacture of a multilayer actuator according to claim 16, **characterised in that** the processing for shaping a multilayer actuator is conducted after sintering.

19. Method for the manufacture of a multilayer actuator according to one of claims 16 to 18, **characterised in that** after the actuator has been sintered the sinter skin is left on its surface, and only the regions for exposure of the electrodes at which the contact surfaces of the internal electrodes are connected to the external electrode are ground.

## Revendications

1. Actionneur piézocéramique multicouche (10), comprenant des électrodes intérieures (11; 30 à 37; 39, 40), amenées en alternance à la surface de l'actionneur, et des zones inactives qui leur sont associées et sont formées chaque fois par deux segments de cercle situés mutuellement en vis-à-vis, découpés dans l'électrode intérieure et ayant des sécantes (14, 15) de même longueur, avec une zone de contact (16) tournée vers l'extérieur qui subsiste sur un côté, les électrodes intérieures de même polarisation étant connectées par les surfaces de contact (17) de leurs zones de contact (16) à l'électrode extérieure (24) respective, en vue du montage en parallèle, et les électrodes extérieures (24) étant disposées sur des côtés opposés de l'actionneur (10), où les surfaces de contact (17), et donc les zones inactives (15) qui leur sont associées, d'une électrode intérieure ou d'un nombre prédéterminé d'électrodes intérieures (11; 30 à 37; 39, 40) de même polarisation, disposées les unes au-dessus des autres dans le même sens, sont décalées d'un angle (22) $\alpha$ par rapport aux surfaces de contact (17), et donc aux zones inactives qui leur sont associées, de l'électrode intérieure précédente ou d'un nombre prédéterminé d'électrodes intérieures précédentes de même polarisation, disposées les unes au-dessus des autres dans le même sens, où l'angle (22) $\alpha$, dont il faut tourner une électrode intérieure par rapport à l'électrode suivante de même polarisation, se calcule de la manière indiquée ci-après, pour une hauteur h prédéfinie des couches de feuille, qui est destinée à éviter la fissuration et avec laquelle au moins les surfaces de contact (17) ne se chevauchent plus :

$$\alpha = \left( \frac{h}{d} \cdot \arcsin\left( \frac{L}{R} \right) \right) \quad .$$

où d (23) est l'épaisseur totale de la feuille à l'état vert (25), conjointement avec l'épaisseur de la couche d'électrode (11), L est la longueur de la sécante (14, 15) du segment de cercle découpé dans la surface en section transversale de l'électrode intérieure (11) et R est le rayon (13) de l'actionneur (10) multicouche.

2. Actionneur piézocéramique multicouche selon la revendication 1, **caractérisé par le fait qu'**après une hauteur (38) prédéfinie et donc après un nombre prédéfini de couches (23), constituées d'une couche de matériau piézocéramique (25) sur lequel est appliquée une électrode intérieure (11), le décalage (41) correspond à un multiple de l'angle (22) prédéterminé et est si grand qu'au moins les surfaces de contact (17) de la première (39) et de la dernière (40) des électrodes intérieures (11) de même polarisation ne se chevauchent plus dans cette zone (38).

3. Actionneur piézocéramique multicouche selon la revendication 1, **caractérisé par le fait qu'**après une portion d'une hauteur (38) prédéfinie et donc après un nombre prédéfini de couches (23), constituées d'une couche de matériau piézocéramique (25) sur lequel est appliquée une électrode intérieure (11), le décalage (41) correspond à un multiple de l'angle (22) prédéterminé et est si grand que les zones inactives (15) de la première (39) et de la dernière (40) des électrodes intérieures (11) de même polarisation ne se chevauchent plus dans cette zone (38).

4. Actionneur piézocéramique multicouche selon une des revendications 1 à 3, **caractérisé par le fait que** le décalage (41) est terminé dans une zone (38) comprise entre environ 0,5 mm et environ 3 mm, ce qui correspond à environ 5 à 30 couches (23) qui se composent chacune du matériau piézocéramique (25) et de l'électrode intérieure (11) appliquée sur celui-ci.

5. Actionneur piézocéramique multicouche selon la revendication 4, **caractérisé par le fait que** le décalage (41) est terminé dans une zone (38) comprise entre environ 1 mm et environ 1,5 mm, ce qui correspond à environ 10 à 15 couches (23).

6. Actionneur piézocéramique multicouche selon une des revendications 1 à 5, **caractérisé par le fait que** suivant la taille de l'actionneur multicouche (10), le décalage (41) est prévu plusieurs fois de suite dans celui-ci.

**7.** Actionneur piézocéramique multicouche selon la revendication 6, **caractérisé par le fait que**, à la fin d'une zone ou de plusieurs zones (38), le décalage (41) est ramené dans le sens opposé, de sorte qu'il en résulte un tracé ondulatoire des décalages.

**8.** Actionneur piézocéramique multicouche selon une des revendications 1 à 7, **caractérisé par le fait que** l'actionneur (10) présente une section (12) circulaire.

**9.** Actionneur piézocéramique multicouche selon la revendication 8, **caractérisé par le fait que** lors de la liaison des surfaces de contact (17) d'électrodes intérieures (11; 30 à 37; 39, 40) de même polarisation, un décalage (41) constant des surfaces de contact (17) donne un tracé hélicoïdal des électrodes extérieures (24).

**10.** Actionneur piézocéramique multicouche selon une des revendications 1 à 7, **caractérisé par le fait que** sa surface en section transversale à la forme d'un carré, d'un rectangle ou d'un polygone.

**11.** Actionneur piézocéramique multicouche selon la revendication 10, **caractérisé par le fait qu'**une électrode extérieure s'étend sur une face latérale ou sur plusieurs faces latérales, en particulier lorsqu'il s'agit d'une section polygonale.

**12.** Actionneur piézocéramique multicouche selon une des revendications 1 à 11, **caractérisé par le fait qu'**il présente un perçage traversant (27), s'étendant dans le sens de son axe longitudinal (26).

**13.** Actionneur piézocéramique multicouche selon une des revendications 1 à 11, **caractérisé par le fait que** des trous borgnes sont prévus à ses extrémités.

**14.** Actionneur piézocéramique multicouche selon une des revendications 1 à 13, **caractérisé par le fait que** dans la partie de tête (28) et dans la partie de base (29) de l'actionneur (10), l'espacement des électrodes intérieures (30 à 33 ou 34 à 37), d'une électrode à l'autre, va en augmentant en direction de l'extrémité respective (28 ou 29) de l'actionneur (10).

**15.** Actionneur piézocéramique multicouche selon une des revendications 1 à 14, **caractérisé par le fait que** l'actionneur (10) fait partie intégrante de la commande d'une soupape d'injection.

**16.** Procédé de fabrication d'un actionneur multicouche selon une des revendications 1 à 15, **caractérisé par le fait que** plusieurs électrodes intérieures de même polarisation sont appliquées respectivement sur une feuille à l'état vert en matériau piézocéramique, avec la même orientation de leurs surfaces de contact pour l'électrode extérieure, **par le fait que** pour obtenir le décalage des surfaces de contact, les électrodes intérieures de même polarisation sont appliquées sur la feuille à l'état vert suivante, avec le décalage respectif d'un angle α prédéterminé par rapport à la position de l'électrode précédente, **par le fait que** les électrodes intérieures de polarisation opposée correspondantes sont appliquées chacune avec une rotation de 180 degrés sur les feuilles à l'état vert, **par le fait qu'**ensuite les feuilles à vert de polarisation opposée sont superposées pour former un bloc, les surfaces de contact, et donc les zones inactives qui leur sont associées, d'une électrode intérieure ou d'un nombre prédéterminé d'électrodes intérieures de même polarisation, disposées les unes au-dessus des autres dans le même sens, étant décalées de l'angle α par rapport aux surfaces de contact, et donc aux zones inactives qui leur sont associées, de l'électrode intérieure précédente ou d'un nombre prédéterminé d'électrodes intérieures précédentes de même polarisation, disposées les unes au-dessus des autres avec la même orientation, et **par le fait que** l'angle de valeur α, dont il faut tourner une électrode intérieure par rapport à l'électrode suivante de même polarisation, se calcule de la manière indiquée ci-après, pour la hauteur h prédéfinie des couches de feuille, qui est destinée à éviter la fissuration :

$$\alpha = \left( \frac{h}{d} \cdot \arcsin\left( \frac{L}{R} \right) \right) \quad ,$$

où d est l'épaisseur totale de la feuille à l'état vert, conjointement avec l'épaisseur de la couche d'électrode, L est la longueur de la sécante du segment de cercle découpé sur la surface en section transversale de l'électrode intérieure et R est le rayon de l'actionneur multicouche, et **par le fait qu'**ensuite les actionneurs sont façonnés à partir de ce bloc.

**17.** Procédé de fabrication d'un actionneur multicouche selon la revendication 16, **caractérisé par le fait que** l'usinage pour former un actionneur multicouche est réalisé à l'état vert, avant l'opération de frittage.

**18.** Procédé de fabrication d'un actionneur multicouche selon la revendication 16, **caractérisé par le fait que** l'usinage pour former un actionneur multicouche est réalisé après le frittage.

**19.** Procédé de fabrication d'un actionneur multicouche selon une des revendications 16 à 18, **caractérisé**

**par le fait qu'**après le frittage de l'actionneur, on conserve la peau de frittage à sa surface, et pour dégager les électrodes, on ponce uniquement les zones où les surfaces de contact des électrodes intérieures sont reliées à l'électrode extérieure.

Fig. 1

Fig. 3

Fig.2

Fig.4

Fig.5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1061591 A1

- EP 0550829 A1